# EUROPEAN PATENT APPLICATION

(11) **EP 4 648 020 A1**
(43) Date of publication of application: **12.11.2025**
(21) Application number: 25174603.8
(22) Date of filing: 06.05.2025
(51) Int. Cl.: G06V 10/25, G06V 20/69

(54) **CLASSIFYING MICROSCOPIC COMPONENTS OF PHYSICAL SAMPLES**

(30) Priority: 06.05.2024 US 202418656163
(71) Applicant: FEI COMPANY, Hillsboro, OR 97124 (US)
(72) Inventor: DURIS, Roman, Trencín (CZ); HRADIL, Jan, Brno (CZ); JAKAB, Matej, Nitrianske Hrnciarovce (SK)
(74) Representative: Boult Wade Tennant LLP

(57) **Abstract**

Disclosed herein are systems for classifying microscopic components of physical samples, as well as related methods, computing devices, and computer-readable media. For example, in some embodiments, a method for classifying microscopic components of a physical sample may include: generating a set of regions-of-interest (ROIs) in an image representative of the physical sample, wherein the image is generated by a microscopy system using a first analysis mode; generating an initial classification for an ROI by applying a trained machine-learning model to at least the portion of the image associated with the ROI; generating a confidence score associated with the initial classification; and when the confidence score for an initial classification of an ROI does not satisfy a set of confidence criteria, causing the microscopy system to re-analyze at least the portion of the sample associated with the ROI using a second analysis mode different than the first analysis mode.

## Description

### Background

There are many types of analytical instruments that may generate data about microscopic features of samples. Different types of such instruments may use different physical principles to generate data about a sample.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a block diagram of an example sample analysis module for performing sample analysis operations, in accordance with various embodiments.
FIG. 2 illustrates an example of an image in which multiple regions-of-interest (ROIs) have been identified, in accordance with various embodiments.
FIG. 3 illustrates example results of an energy dispersive spectroscopy (EDS) analysis on a portion of a sample associated with a particular ROI, in accordance with various embodiments.
FIG. 4 is a flow diagram of an example method of performing sample analysis operations, in accordance with various embodiments.
FIG. 5 is a flow diagram of an example method of generating a machine-learning model for classifying microscopic components of a physical sample, in accordance with various embodiments.
FIG. 6 is a flow diagram of a method of creating new classifications for previously unclassified ROIs, in accordance with various embodiments.
FIG. 7 is an example of a graphical user interface (GUI) that may be used in the performance of some or all of the sample analysis methods disclosed herein, in accordance with various embodiments.
FIG. 8 is a block diagram of an example computing device that may perform some or all of the sample analysis methods disclosed herein, in accordance with various embodiments.
FIG. 9 is a block diagram of an example sample analysis system in which some or all of the sample analysis methods disclosed herein may be performed, in accordance with various embodiments.

### Detailed Description

Disclosed herein are systems for classifying microscopic components of physical samples, as well as related methods, computing devices, and computer-readable media. For example, in some embodiments, a method for classifying microscopic components of a physical sample may include: generating a set of regions-of-interest (ROIs) in an image representative of the physical sample, wherein the image is generated by a microscopy system using a first analysis mode; generating an initial classification for an ROI by applying a trained machine-learning (ML) model to at least the portion of the image associated with the ROI; generating a confidence score associated with the initial classification; and when the confidence score for an initial classification of an ROI does not satisfy a set of confidence criteria, causing the microscopy system to re-analyze at least the portion of the sample associated with the ROI using a second analysis mode different than the first analysis mode.

As discussed in further detail below, many scientific and industrial applications may benefit from an accurate classification of the microscopic components of samples (e.g., to avoid using "dirty" components in an assembly process, to ensuring that materials have adequate quality before further processing, to facilitating effective law enforcement by fast analysis of crime scene samples, etc.). In many such applications, generating an accurate classification as quickly as possible is critical to enabling the timely use of this information. The need for speed is particularly important in high-volume analysis applications in which there are many samples that need analysis (e.g., every tenth part in some automotive manufacturing processes) and longer processing times can result in undesirable backlog. In some applications, the analysis must be non-destructive to the samples, must be repeatable to a high degree (e.g., 93-99% of particles detected and matched), and/or must be reproducible when different microscopy systems are used (e.g., so that the classification results of imaging a sample using one microscope match the classification results of imaging the sample using a different microscope, with some applications specifying only a +/-8% tolerance for error or less as part of the site acceptance test).

Disclosed herein are sample analysis techniques and systems that may enable the accurate classification of microscopic components of samples much more quickly than conventional classification systems. The techniques and systems disclosed herein may utilize machine learning technology, and may be implemented without requiring a human user to set aside additional time to painstakingly create a set of training data (as is usually required for ML tools). Further, various embodiments of the techniques and systems disclosed herein provide an autonomous or semi-autonomous process for the development of an ML-based classifier, enabling model training and distribution with little to no human effort. Once in place, the ML-based techniques and systems disclosed herein may enable the classification of components of samples much faster than conventional classification systems, with the potential for orders of magnitude of improvement in the evaluation time of a sample.

Thus, the sample analysis embodiments disclosed herein may achieve improved performance relative to conventional approaches. In particular, the embodiments disclosed herein thus provide improvements to scientific instrument technology (e.g., improvements in the computer technology supporting such scientific instruments, among other improvements). Various ones of the embodiments disclosed herein may improve upon conventional approaches to achieve the technical advantages of faster classification of microscopic components of physical samples by autonomous or semi-autonomous training and deployment of ML models to at least partially replace time-consuming conventional analysis techniques and achieve higher throughput. Such technical advantages are not achievable by routine and conventional approaches, and all users of systems including such embodiments may benefit from these advantages. The technical features of the embodiments disclosed herein are thus decidedly unconventional in the field of sample analysis, as are the combinations of the features of the embodiments disclosed herein. As discussed further herein, various aspects of the embodiments disclosed herein may improve the functionality of a computer itself; for example, a computing system that analyzes sample analysis data. The computational and user interface features disclosed herein do not only involve the collection and comparison of information, but apply new analytical and technical techniques to change the operation of systems that employ microscopic feature classification as part of a scientific or industrial process. The present disclosure thus introduces functionality that neither a conventional computing device, nor a human, could perform.

Accordingly, the embodiments of the present disclosure may serve any of a number of technical purposes, such as controlling a specific technical system or process; determining from measurements (e.g., classification of microscopic components of a sample) how to control a machine or process; digital image enhancement or analysis; and providing a faster processing of analytical instrument data.

The embodiments disclosed herein thus provide improvements to analytical instrument and sample analysis technology (e.g., improvements in the computer technology supporting sample analysis, among other improvements).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the subject matter disclosed herein. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices. As used herein, the phrase "based on" should be understood to mean "based at least in part on," unless otherwise specified.

The description uses the phrases "an embodiment," "various embodiments," and "some embodiments," each of which may refer to one or more of the same or different embodiments. Furthermore, the terms "comprising," "including," "having," and the like, as used with respect to embodiments of the present disclosure, are synonymous. When used to describe a range of dimensions, the phrase "between X and Y" represents a range that includes X and Y. As used herein, an "apparatus" may refer to any individual device, collection of devices, part of a device, or collections of parts of devices. The drawings are not necessarily to scale.

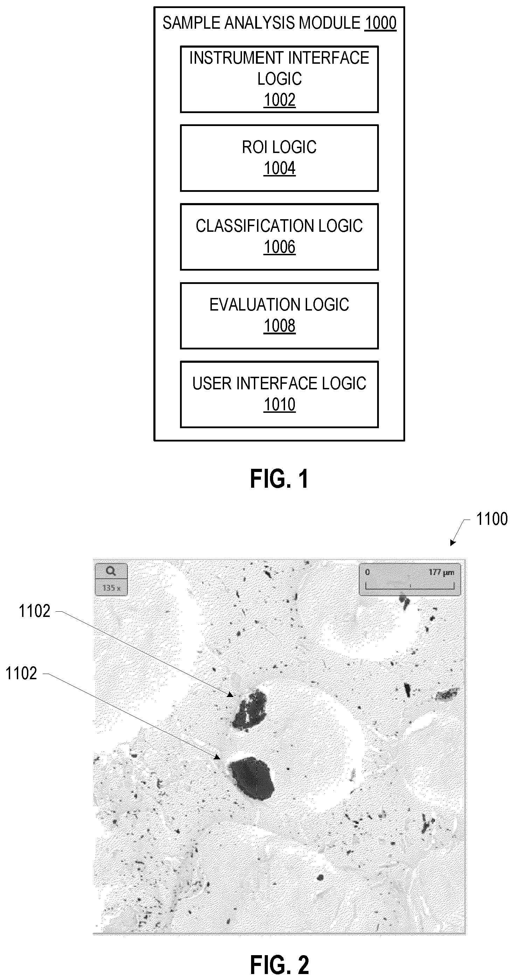

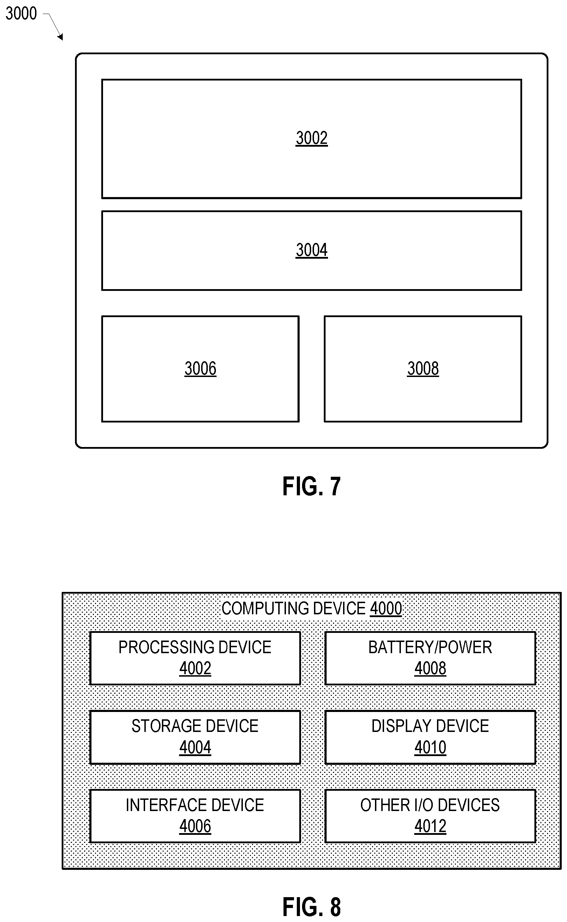

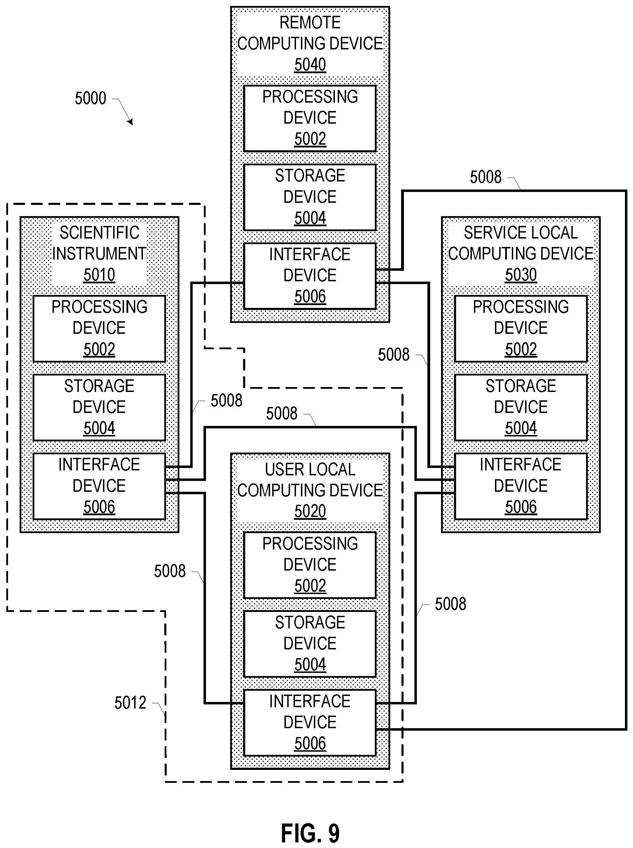

FIG. 1 is a block diagram of a sample analysis module 1000 for performing sample analysis operations, in accordance with various embodiments. The sample analysis module 1000 may be implemented by circuitry (e.g., including electrical and/or optical components), such as a programmed computing device. The logic of the sample analysis module 1000 may be included in a single computing device, or may be distributed across multiple computing devices that are in communication with each other as appropriate. Examples of computing devices that may, singly or in combination, implement the sample analysis module 1000 are discussed herein with reference to the computing device 4000 of FIG. 8, and examples of systems of interconnected computing devices, in which the sample analysis module 1000 may be implemented across one or more of the computing devices, is discussed herein with reference to the sample analysis system 5000 of FIG. 9.

The sample analysis module 1000 may include instrument interface logic 1002, region-of-interest (ROI) logic 1004, classification logic 1006, evaluation logic 1008, and user interface logic 1010. As used herein, the term "logic" may include an apparatus that is to perform a set of operations associated with the logic. For example, any of the logic elements included in the sample analysis module 1000 may be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" may refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module may not include all of the logic elements depicted in the associated drawing; for example, a module may include a subset of the logic elements depicted in the associated drawing when that module is to perform a subset of the operations discussed herein with reference to that module.

The instrument interface logic 1002 may allow the sample analysis module 1000 to communicate with one or more scientific instruments, such as one or more microscopes (e.g., charged particle microscopes). In some embodiments, this communication may include receiving data (e.g., data collected using one or more analysis modes of the scientific instrument) from one or more scientific instruments, and/or providing commands or instructions to one or more scientific instruments (e.g., to cause a microscope to image a sample using a specified analysis mode and over a specified ROI). In various ones of the embodiments disclosed herein, a scientific instrument generating data that will be analyzed by the sample analysis module 1000 may have multiple possible acquisition modes. These modes may generate different kinds of data, and the selection of one mode or another for analysis may require a balancing of competing factors. For example, some acquisition modes may generate images with higher information density than other modes, but at a cost of greater acquisition time, greater power requirements, greater risk of damage to a sample, or other factors. Some microscopy systems, for example, may be configured to be able to perform in a backscattered electron detection (BSED) analysis mode and also to perform in an energy dispersive spectroscopy (EDS) analysis mode; compared to BSED, EDS may provide additional information about the elemental composition of a sample, but may take much more time (e.g., 1000x more to image a same area).

BSED and EDS may be used herein as an example of a pair of analysis types that provide different kinds or amounts of information about a sample and in which one analysis type is more resource-intensive than the other analysis type, but there are many other analysis type pairs to which the innovative systems and methods disclosed herein may be applied. For example, the first, less resource-intensive analysis type may include any of secondary electron detector (SED) analysis, low vacuum detector (LVD) analysis, circular backscatter detector (CBS) analysis, Everhart-Thornley detector (ETD) analysis, BSED analysis, specific detector analysis (e.g., from in-lens detectors T1 or T2, and/or an in-column detector T3), visible light analysis, infrared light analysis, or ultraviolet light analysis, and the second, more resource-intensive analysis type may include any of EDS analysis, electron backscatter diffraction (EBSD) analysis, electron energy loss spectroscopy (EELS) analysis, cathode luminescence (CL) analysis, or wavelength-dispersive x-ray spectroscopy (WDS) analysis.

The ROI logic 1004 may identify one or more ROIs in an image of a physical sample. The image may be constructed from data generated by a scientific instrument (e.g., a charged particle microscope), and may represent the use of one or more analysis modes by the scientific instrument. As used herein, an "image" includes two-dimensional data representation and suitable higher dimensional data representations. For example, a multi-channel image may include multiple two-dimensional images, one corresponding to each channel (e.g., three two-dimensional images for red-green-blue (RGB) image capture devices). In another example, when an image is generated by data from multiple detectors (e.g., a BSED and an SED), the resulting image may be a three-dimensional matrix (represented by, e.g., (w,h,x) coordinates in which w is width, h is height and x is a vector of data corresponding to the different detectors). An ROI may identify a particular portion of the image that corresponds to a feature of interest of the physical sample, with the particular features that are of interest for a particular sample depending upon the nature of the sample and the purpose of the sample analysis. In some embodiments, an individual ROI may correspond to an individual particle in the physical sample. In some embodiments, an individual ROI may correspond to a cluster of particles in the physical sample (e.g., a stringer in a steel sample). In some embodiments, an individual ROI may correspond to a structure of interest in a biological sample (e.g., a cell nucleus).

The ROI logic 1004 may use any suitable technique to identify the ROIs in an image. In some embodiments, the ROI logic 1004 may apply a conventional segmentation technique, such as a machine-learning (ML)-based segmentation technique or any other computer vision-based technique (e.g., thresholding, edge detection, etc.) as known in the art, to identify the ROIs. In some embodiments in which the ROI logic 1004 is to determine ROIs in a BSED image, the ROI logic 1004 may employ a BSED thresholding technique, in which pixels whose intensity falls within a particular range are used to identify ROIs, as known in the art.

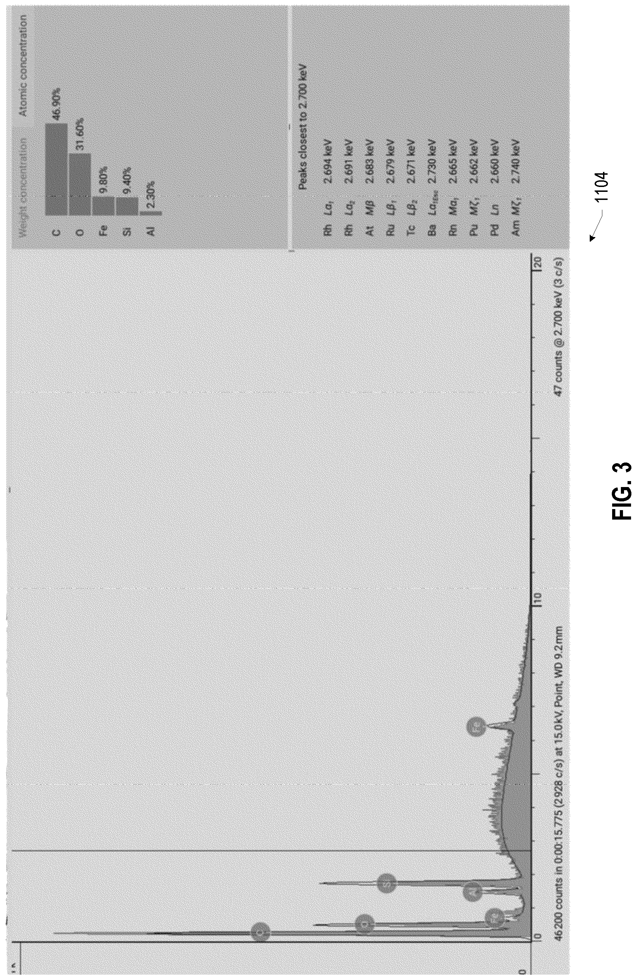

FIG. 2 illustrates an example of an image 1100 in which multiple ROIs 1102 have been identified as shown by the highlighted areas. The image 1100 may represent only a portion of a sample, and may be one of many images 1100 tiled or otherwise arranged to represent a field of view. Only a few of the ROIs 1102 identified in the image 1100 are labeled in FIG. 2. The image 1100 (which may be, for example, a BSED image) may be generated or received by the instrument interface logic 1002, and the ROIs 1102 identified by the ROI logic 1004. FIG. 3 illustrates example results 1104 of an EDS analysis on a portion of a sample associated with a particular ROI 1102 identified in an image 1100. The results 1104 may include peaks 1106 corresponding to different elements present in the portion of the sample.

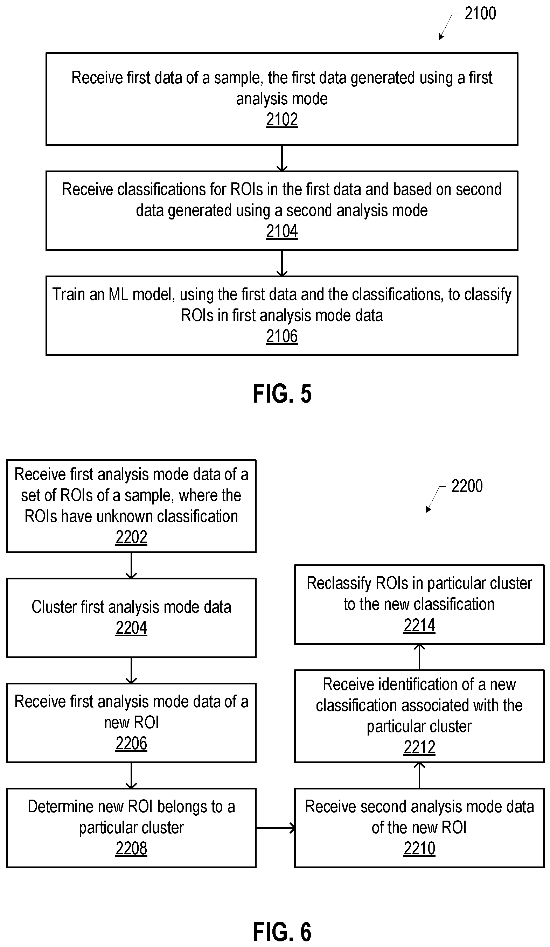

The classification logic 1006 may store one or more ML models that can be used to generate a classification for a particular ROI identified by the ROI logic 1004. The classification logic 1006 may apply an ML model to an ROI to generate such a classification. The classification logic 1006 may generate new ML models based on classifications previously performed (e.g., manually or using a rules-based process). An example method for creating new ML models for classification of ROIs in images of physical samples is discussed below with reference to FIG. 5. In some embodiments, the classification logic 1006 may retrain or otherwise update stored ML models (e.g., based on additional available data). In some embodiments, the classification logic 1006 may deploy one or more ML models to computing devices connected to or included in scientific instruments so that those ML models can be run on those computing devices to data generated by the associated scientific instruments. In some embodiments, the ML models applied by the classification logic 1006 may be received by the classification logic 1006 from a central server (e.g., the remote computing device 5040 of FIG. 9, discussed below), which may be configured to deploy the ML models to multiple microscopy systems. In other embodiments, the classification logic 1006 itself may deploy one or more ML models to other microscopy systems.

The set of possible classifications (e.g., two or more) that may be generated by an ML model of the classification logic 1006 may depend on the particular application (e.g., law enforcement, automotive, battery manufacturing, steel processing, etc.) and how the ML model was trained. For example, in some law enforcement applications in which materials are analyzed, the set of possible classifications may include gunshot residue (GSR) and not GSR. In some automotive applications in which the cleanliness of parts may be assessed before assembly, the set of possible classifications may include abrasive (a characterization that may include particles of silicon carbide and other materials) and soft (a characterization that may include aluminum and other materials).

The architecture of an ML model used by the classification logic 1006 may take any of a number of forms. In some embodiments, the ML model may take the form of a classifier model as known in the art, such as a fully connected neural network. The input to the ML model may be a two-dimensional image or a one-dimensional vector. In some embodiments, a two-dimensional image provided as input to the ML model may be a BSED or other image output by a first analysis mode of an ROI. In some embodiments, a one-dimensional vector provided as input to the ML model may include a set of morphological parameters of the ROI generated based on the results of a first analysis mode. For example, a binary mask may be applied to a BSED or other image to isolate the ROIs, and then morphological properties of the ROIs may be calculated using techniques known in the art; the input to the ML model may then be, for a particular ROI, a vector of its morphological characteristics. Examples of morphological characteristics that may be calculated may include, but are not limited to, size, area, roundness, sharpness, elongation, aspect ratio, form factor, perimeter length, area, brightness level, void count, void area, or skeleton length. In some embodiments, the input to an ML model may include both two-dimensional image data and calculated morphological characteristics of an ROI. The output of the ML model may be a classification of the ROI based on the number and kinds of classifications used in the particular application (e.g., GSR or not GSR, abrasive or soft, etc.).

The classification logic 1006 may also include user-defined rules (sometimes included in a "rule file") to apply to data generated by various analysis modes to arrive at a classification for an associated ROI, different from an ML model that generates such classifications. These additional rules may be used when further information is available about an ROI (e.g., when the portion of the physical sample corresponding to that ROI is imaged using multiple different analysis modes). For example, if a physical sample is imaged using EDS, and the EDS provides information about the elemental composition of the portion of the physical sample corresponding to an ROI, the classification logic may store rules in which that elemental composition information (potentially in conjunction with properties of the ROI, such as its size, roughness, etc.) can be compared to determine the appropriate classification for the ROI. Other analysis modes may provide other kinds of information that can be part of a set of classification rules (e.g., the crystalline structure rotation information provided by EBSD).

In some embodiments, an ML model implemented by the classification logic 1006 may be trained using previous classifications (e.g., input-output pairs that include image/morphological data of individual ROIs and the classifications of those ROIs). This training may begin when the module 1000 is first deployed to a particular site for a particular application, or as soon as the application area is known and the training data is available. In some embodiments, an ML model may be refined or initially trained based on data that becomes available to the module 1000 after deployment. For example, a microscopy system may initially generate BSED and EDS data for every ROI (when both analysis modes are available), use the user-defined rules to generate classifications for those ROIs, and then use that data (with BSED and BSED-derived data as the inputs, and the classifications as the outputs in the training set) to initially train an ML model to perform the classifications or improve the performance of a previously trained ML model. In this way, as the ML model's classification performance improves (as determined by the evaluation logic 1008, as discussed below), fewer ROIs may need to be analyzed with EDS for accurate classifications to be determined, resulting in significant time savings.

In some embodiments, a ROI's classification may be "unclassified," meaning that the appropriate classification of the ROI is unknown. This may occur when the ML model of the classification logic 1006 outputs an "unclassified" result (e.g., when the confidence in a particular classifications is low, as determined by the evaluation logic 1008 as discussed below), when the ROI cannot be re-analyzed using a second analysis mode (e.g., when a particular microscopy system is not configured to analysis using a second mode), and/or when the results of the analysis after the second analysis mode (e.g., in accordance with stored rules applied by the classification logic 1006) do not correspond to any known classifications. In some such instances, when the classification of an ROI is unclassified, the classification logic 1006 may store the "unclassified" classification for the ROI, and may update the classification for the ROI upon notification from a central server that a classification is available. A classification may become available under any of a number of circumstances, such as improving the performance of the ML models to account for the previously unclassified ROIs, creating a new ML model to properly classify the previously unclassified ROIs, and/or the creation of new rules that can handle the previously unclassified ROIs. An example of a method of creating new classifications for previously unclassified ROIs is discussed below with reference to FIG. 6.

The evaluation logic 1008 may evaluate a classification of an ROI generated by the classification logic 1006 to determine whether the confidence in the classification is high enough for the classification to be accepted for that ROI. In some embodiments, the classification logic 1006 may generate a confidence score along with its classification using techniques known in machine learning, and the evaluation logic 1008 may compare that confidence score to a predetermined threshold to determine whether the classification of the ROI should be accepted (e.g., stored, included in a report assembled by the user interface logic 1010, etc.) or whether the ROI should be re-analyzed (e.g., using a different, more resource-intensive analysis modality, like EDS) to generate data that can be used to generate a higher-confidence classification of the ROI. In some embodiments, the confidence score may be a value between 0 and 1, as known in the art, although the range of confidence score may be scaled to any desired range. The evaluation logic 1008 may compare the confidence score to a threshold (e.g., 0.95 or another value), and may accept a classification whose confidence meets or exceeds that threshold (and may otherwise reject the classification).

In some embodiments, the evaluation logic 1008 may track the confidence of an ML model of the classification logic 1006 over time, and may monitor for confidence trends that indicate that the ML model's performance for certain output classifications or for all classifications is decreasing or has dropped below a threshold. If such a performance decrease condition is identified by the evaluation logic 1008, the evaluation logic 1008 may cause the classification logic 1006 to retrain the ML model on additional data in order to improve performance. Causing the classification logic 1006 to retrain may mean causing the instrument interface logic 1002 to collect more data using both the first and second analysis modes, to which the user-defined rules can be applied to generate classifications, and the resulting data and classifications can be provided to the classification logic 1006 to retrain the ML model.

The user interface logic 1010 may provide information to and/or receive information from a human user of the analysis module 1000. In some embodiments, the user interface logic 1010 may aggregate information about a physical sample into a report that includes information about the ROIs identified in images of the physical sample. That report may be provided to a user for visual display, for electronic transmission, or for use by a quality control or other system to aid in making automated or semi-automated decisions about downstream processing or handling of the physical sample or upstream parameters (e.g., whether previous processing steps were performed correctly, whether raw materials had appropriate characteristics, whether the quality of a manufactured material meets a specified standard, etc.). In some embodiments in which the systems and methods disclosed herein are utilized as part of a particle analysis (PA) workflow, a report output by the user interface logic 1010 may identify all of the identifiable particles of a physical sample and their associated classifications. A number of examples of reports that may be generated by the user interface logic 1010 are discussed herein..

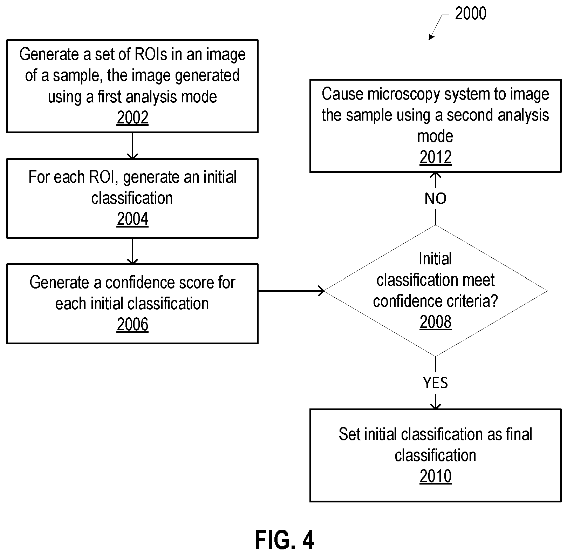

The sample analysis module 1000 may perform any of a number of sample analysis methods. FIG. 4 is a flow diagram of a method 2000 of performing sample analysis operations, in accordance with various embodiments. In particular, the method 2000 is a method for classifying microscopic components of a physical sample. Although the operations of the method 2000 (and the other methods disclosed herein) may be illustrated with reference to particular embodiments disclosed herein (e.g., the sample analysis modules 1000 discussed herein with reference to FIG. 1, the GUI 3000 discussed herein with reference to FIG. 7, the computing devices 4000 discussed herein with reference to FIG. 8, and/or the sample analysis system 5000 discussed herein with reference to FIG. 9), the method 2000 (and the other methods disclosed herein) may be used in any suitable setting to perform any suitable sample analysis operations. Operations are illustrated once each and in a particular order in FIG. 4, but the operations may be reordered and/or repeated as desired and appropriate (e.g., different operations performed may be performed in parallel, as suitable).

At 2002, a set of ROIs in an image representative of the physical sample may be generated. The image itself may be generated by a microscopy system using a first analysis mode. The ROI logic 1004 of a sample analysis module 1000 may perform the operations of 2002 based on data provided by the instrument interface logic 1002 of the sample analysis module 1000. In some embodiments, generating the set of ROIs at 2002 includes applying an ML-based segmentation technique to the image. The particular ROIs identified will depend on the application. For example, in some applications, an individual ROI identified at 2002 may correspond to an individual particle in the physical sample.

At 2004, an initial classification for an individual ROI (of the set generated at 2002) may be generated by applying a trained ML model to at least the portion of the image associated with the ROI. The classification logic 1006 of a sample analysis module 1000 may perform the operations of 2004. As noted above, the set of possible classifications (e.g., two or more) that may be generated at 2004 will depend on the particular application and how the ML model was trained. For example, in some law enforcement applications, the initial classification for an ROI at 2004 may be selected from a set of at least two classifications, and the set of at least two classifications includes GSR and not GSR. In some automotive applications, the initial classification for an ROI at 2004 may be selected from a set of at least two classifications, and the set of at least two classifications includes abrasive and soft. In some embodiments, the ML model applied at 2004 may be received by the classification logic 1006 from a central server (e.g., the remote computing device 5040 of FIG. 9, discussed below), which may be configured to deploy the ML model to multiple microscopy systems. In other embodiments, the classification logic 1006 itself may deploy the ML model to other microscopy systems.

At 2006, a confidence score associated with the initial classification (generated at 2004) may be generated. The classification logic 1006 of a sample analysis module 1000 may perform the operations of 2006, and in some particular embodiments, may do so in conjunction or simultaneously with the generation of the initial classification at 2004.

At 2008, whether an initial classification of an individual ROI satisfies a set of one or more confidence criteria may be determined. The evaluation logic 1008 of a sample analysis module 1000 may perform the operations of 2008. In some embodiments, the operations of 2008 may include comparing a confidence score (generated at 2006) with a threshold value; when the confidence score exceeds the threshold, the confidence criteria may be satisfied.

If it is determined at 2008 that the initial classification meets the confidence criteria, the method 2000 may proceed to 2010 and the initial classification may be set as the final classification for the associated ROI. The user interface logic 1010 of a sample analysis module 1000 may perform the operations of 2010.

If it is determined at 2008 that the initial classification does not meet the confidence criteria, the method 2000 may proceed to 2012 and the microscopy system may be caused to re-analyze at least the portion of the sample associated with the ROI using a second analysis mode different than the first analysis mode (e.g., perform an EDS analysis after an initial BSED analysis). The instrument interface logic 1002 of a sample analysis module 1000 may perform the operations of 2012. In some embodiments, the microscopy system takes less time to image the portion of the sample associated with the ROI using the first analysis mode (the mode used to generate the image analyzed at 2002) than using the second analysis mode (the mode triggered at 2012 by failing to meet the confidence criteria of 2008). For example, in some embodiments, generating a confidence score associated with the initial classification, the first analysis mode may be or include BSED and the second analysis mode may be or include EDS. Because another round of imagine using the second analysis mode may not be triggered unless the initial classification fails to meet the confidence criteria, it is expected that not all of the ROIs generated at 2002 will need to be re-analyzed as long as the ML model used in the initial classification at 2004 has adequate performance (e.g., once the ML model has been adequately trained), and thus the performance of the method 2000 may require less time to analyze the physical sample than a conventional method in which all of the ROIs are imaged using a second analysis mode.

In some embodiments, the method 2000 may further include, after re-analyzing the sample at 2012, using data generated by the re-analysis to generate a final classification for the ROI. The classification logic 1006 may include rules to apply to data generated by the second analysis mode (potentially in conjunction with the first image and/or properties of the ROI) to arrive at a classification for the associated ROI. For example, if the second analysis mode is EDS, and re-analyzing an ROI with EDS provides information about the elemental composition of the portion of the physical sample corresponding to an ROI, that elemental composition information (potentially in conjunction with properties of the ROI, such as its size, roughness, etc.) may be compared to a set of pre-stored rules that determine the appropriate classification for the ROI.

Once the method 2000 has been performed for all of the ROIs of a particular physical sample, the user interface logic 1010 may then report, store, electronically transmit, or otherwise use the final ROI classification for each of the ROIs. In some embodiments, the user interface logic 1010 may output a classification report that includes the final classification of individual ROIs in the set of ROIs. The classification report may include any other suitable information, such as the locations of individual ROIs, morphological characteristics of the portion of the sample corresponding to individual ROIs (e.g., area, roundness, or roughness), compositional information of the portion of the sample corresponding to individual ROIs (e.g., gunpowder, aluminum oxide, etc.) and/or any other suitable information.

As noted above, in some embodiments of the method 2000, a ROI's initial and/or final classification may be "unclassified," meaning that the appropriate classification of the ROI is unknown (e.g., the classification is determined at 2008 not to satisfy the confidence criteria for an "accepted" classification) . In some embodiments, the method 2000 may include, when the classification of an ROI is unclassified, the classification logic 100 may store the "unclassified" classification for the ROI, and may update the classification for the ROI upon notification from a central server that a classification is available.

As noted above, in some embodiments, the sample analysis module 1000 may generate new ML models. FIG. 5 is a flow diagram of a method 2100 of generating an ML model for classifying microscopic components of a physical sample, in accordance with various embodiments. Operations are illustrated once each and in a particular order in FIG. 5, but the operations may be reordered and/or repeated as desired and appropriate (e.g., different operations performed may be performed in parallel, as suitable).

At 2102, first data representative of a sample may be received. The first data may be generated using a first analysis mode (e.g., of a microscopy system). The instrument interface logic 1002 may perform the operations of 2102.

At 2104, classifications may be received. The classifications may correspond to ROIs in the first data, the classifications may have been determined using second data, and the second analysis mode (e.g., of a microscopy system) different than the first analysis mode. The classification logic 1006 may perform the operations of 2104. In some embodiments, the classifications may have been manually generated by human users or generated using a rules-based process. In some embodiments, the microscopy system takes less time to image a portion of a sample using the first analysis mode than using the second analysis mode (e.g., the first analysis mode may be or include BSED, and the second analysis mode may be or include EDS or another method that may generate elemental composition data about the portion of the sample). In some embodiments, an individual ROI in the first data corresponds to an individual particle in the physical sample. In some such embodiments, the classifications received at 2104 may be selected from a set of at least two classifications (e.g., gunshot residue (GSR) and not GSR, abrasive and soft, etc.).

At 2106, an ML model may be trained, using the first data and the classifications, to classify ROIs in first analysis mode data. The classification logic 1006 may perform the operations of 2106. In some embodiments, training the ML model using the first data and the classifications may include training the machine-learning model using the first analysis data, morphological parameters generated at least in part from the first analysis data (e.g., area, roundness, roughness, etc.), or a combination of both. In some embodiments, the ML model of 2106 may be configured to receive, as an input, a two-dimensional image (e.g., one or more images included in the first data), a one-dimensional vector (e.g., a vector of morphological parameters), or a combination of both (e.g., a two-dimensional image represented as an array, concatenated with or otherwise combined with the data in a one-dimensional vector of morphological parameters).

In some embodiments, the operations of 2106 may include, after training the ML model, generating a training performance score (e.g., by the classification logic 1006). In such embodiments, the training performance score may be compared to pre-determined training performance criteria (e.g., by the evaluation logic 1008). If the training performance score does not meet the training performance criteria (e.g., the classification performance of the ML model is not adequate), the ML model may be retrained based on additional first data and additional corresponding classification data (e.g., by the classification logic 1006). If the training performance score meets the training performance criteria, the ML model may be provided (e.g., by the classification logic 1006) to generate classifications for ROIs in additional images of physical samples, wherein the additional images are generated by the microscopy system using the first analysis mode. In this manner, an ML model may not be deployed until its classification performance is adequate.

In some embodiments, the method 2100 may include generating the ROIs in the first data after receipt of the first data at 2102. The ROI logic 1004 may generate the ROIs in such embodiments. In some such embodiments, generating the ROIs may include applying a machine-learning segmentation technique to the first data (received at 2102).

In some embodiments, the method 2100 may include, after training the ML model at 2106, deploying the ML model (e.g., to multiple microscopy systems), in accordance with any of the embodiments discussed herein (e.g., as discussed above with reference to the classification logic 1006 and/or to the operations of 2004 of the method 2100).

As noted above, in some embodiments in which when the initial classification of an ROI is "unclassified," the classification logic 1006 may store the "unclassified" classification for the ROI, and may update the classification for the ROI upon notification from a central server that a classification is available. FIG. 6 is a flow diagram of a method 2200 of creating new classifications for previously unclassified ROIs, in accordance with various embodiments. Operations are illustrated once each and in a particular order in FIG. 6, but the operations may be reordered and/or repeated as desired and appropriate (e.g., different operations performed may be performed in parallel, as suitable).

At 2202, first analysis mode data representative of a set of ROIs of a sample may be received. The ROIs associated with the first analysis mode data received at 2202 may have been previously classified by a machine-learning model as not corresponding to a known classification (e.g., "unclassified"), and the first analysis mode data may have been generated by a microscopy system using a first analysis mode (e.g., BSED). The instrument interface logic 1002 may perform the operations of 2202. In some embodiments, an individual ROI corresponds to an individual particle in the physical sample, while in other embodiments, an individual ROI may correspond to different components or areas in a sample (e.g., a particular structure or component of a biological or non-biological sample).

At 2204, the first analysis mode data may be clustered. The classification logic 1006 may perform the operations of 2204. In some embodiments, the first analysis mode data may be clustered at 2204 based on similarities between the first analysis mode data corresponding to different ROIs (e.g., the more similar the first analysis mode data associated with a first ROI is to first analysis mode data associated with a second ROI, the more closely the two sets of first analysis mode data may be clustered). Accordingly, the present disclosure may refer to clustering of ROIs associated with the first analysis mode data.

At 2206, new first analysis mode data representative of a new ROI may be received. The instrument interface logic 1002 may perform the operations of 2206.

At 2208, the new first analysis mode data may be determined to belong to a particular one of the clusters generated at 2204. This determination may be based on a comparison of the new first analysis mode data to the analysis mode data clustered at 2204, with the new first analysis mode data being included in the particular cluster with the most similar previously received first analysis mode data. The classification logic 1006 may perform the operations of 2208.

At 2210, second analysis mode data representative of the new ROI may be received. The second analysis mode data may be generated by a microscopy system using a second analysis mode different from the first analysis mode (associated with the data received at 2202). The instrument interface logic 1002 may perform the operations of 2210. In some embodiments, the microscopy system may take less time to image the portion of the sample associated with the ROI using the first analysis mode than using the second analysis mode. For example, the first analysis mode may include BSED and the second analysis mode may include EDS.

At 2212, an identification of a new classification associated with the particular cluster (to which the new ROI was determined to belong at 2208) may be received, and at 2214, the ROIs in the particular cluster may be reclassified to the new classification. The user interface logic 1010 may perform the operations of 2212, and the classification logic 1006 may perform the operations of 2214. In some embodiments, the identification received at 2212 may be specified by a user, while in other embodiments, the identification may be automatically generated. For example, in some embodiments, a user may review the first analysis mode data (received at 2202 and 2206) of the ROIs included in the particular cluster, and in conjunction with the additional information provided by the second analysis mode data (received at 2210), may determine that the previously "unclassified" ROIs in the particular cluster should all be assigned a new classification (e.g., a new type of contaminant, a new type of particle, etc.), and the user may provide that new classification to the particular cluster. In some embodiments, the user interface logic 1010 may facilitate the operations of 2012 by providing a list of ROIs in the particular cluster and the second analysis mode data to a user through a GUI (e.g., as discussed below with reference to FIG. 7), and that GUI may allow the user to type or otherwise enter a new classification that can be assigned to all or some of the ROIs in the particular cluster. In other embodiments, a new classification may be automatically identified by the module 1000 based on other data available to the module 1000.

In some embodiments, the method 2200 may further include, after re-classifying the ROIs at 2212, outputting a classification report that includes the classifications of individual ROIs of the physical sample. The user interface logic 1010 may perform such operations. The classification report may include locations of individual ROls, morphological characteristics of the portions of the physical sample corresponding to individual ROIs, and/or any other available or derived information about the physical sample.

In some embodiments, the methods disclosed herein may be performed by individual microscopy systems and/or by a central server in communication with multiple microscopy systems. For example, in some implementations, a central server may receive classification-related data, train and retrain an ML model to perform classification, and once the performance of the ML model exceeds a threshold, the ML model may be pushed to different microscopy systems in communication with the server; the different microscopy systems may then use the ML model to perform classification of components of samples analyzed. In some embodiments, the method 2200 of identifying appropriate classifications for previously unclassified ROIs may be performed by a central server, which may be configured to update the ML models and/or previous classifications with new classifications once available.

As discussed herein with reference to the user interface logic 1010 of the sample analysis module 1000, the sample analysis methods disclosed herein may include interactions with a human user (e.g., via the user local computing device 5020 discussed herein with reference to FIG. 9). These interactions may include providing information to the user (e.g., information regarding a sample being analyzed or other test or measurement performed by a scientific instrument such as the scientific instrument 5010 of FIG .9, discussed below, information retrieved from a local or remote database, or other information) or providing an option for a user to input commands (e.g., to control the operation of a scientific instrument such as the scientific instrument 5010 of FIG. 9, or to control the analysis of data generated by a scientific instrument), queries (e.g., to a local or remote database), or other information. In some embodiments, these interactions may be performed through a GUI that includes a visual display on a display device (e.g., the display device 4010 discussed herein with reference to FIG. 8) that provides outputs to the user and/or prompts the user to provide inputs (e.g., via one or more input devices, such as a keyboard, mouse, trackpad, or touchscreen, included in the other I/O devices 4012 discussed herein with reference to FIG. 8). The sample analysis systems disclosed herein may include any suitable GUIs for interaction with a user.

FIG. 7 depicts an example GUI 3000 that may be used in the performance of some or all of the sample analysis methods disclosed herein, in accordance with various embodiments. As noted above, the GUI 3000 may be provided on a display device (e.g., the display device 4010 discussed herein with reference to FIG. 8) of a computing device (e.g., the computing device 4000 discussed herein with reference to FIG. 8) of a sample analysis system (e.g., the sample analysis system 5000 discussed herein with reference to FIG. 9), and a user may interact with the GUI 3000 using any suitable input device (e.g., any of the input devices included in the other I/O devices 4012 discussed herein with reference to FIG. 8) and input technique (e.g., movement of a cursor, motion capture, facial recognition, gesture detection, voice recognition, actuation of buttons, etc.).

The GUI 3000 may include a data display region 3002, a data analysis region 3004, a scientific instrument control region 3006, and a settings region 3008. The particular number and arrangement of regions depicted in FIG. 7 is simply illustrative, and any number and arrangement of regions, including any desired features, may be included in a GUI 3000.

The data display region 3002 may display data generated by a scientific instrument (e.g., the scientific instrument 5010 discussed herein with reference to FIG. 9). For example, the data display region 3002 may display image or other data (e.g., EDS data) representative of a physical sample (e.g., data generated by one or more microscopy systems and received by the instrument interface logic 1002 of the sample analysis module 1000). In some embodiments, one or more ROIs identified by the ROI logic 1004 may be displayed on or with the associated image data in the data display region 3002.

The data analysis region 3004 may display the results of data analysis (e.g., the results of analyzing the data illustrated in the data display region 3002 and/or other data). For example, the data analysis region 3004 may display computed morphological characteristics of individual ROIs, locations of individual ROIs, classifications of ROIs (e.g., as generated by the classification logic 1006 and evaluated by the evaluation logic 1008). In some embodiments, the data analysis region 3004 may include a classification report, as discussed herein, or may include an option for a user to download or send a classification report. In some embodiments, the data display region 3002 and the data analysis region 3004 may be combined in the GUI 3000 (e.g., to include data output from a scientific instrument, and some analysis of the data, in a common graph or region).

The scientific instrument control region 3006 may include options that allow the user to control a scientific instrument (e.g., the scientific instrument 5010 discussed herein with reference to FIG. 9). For example, the scientific instrument control region 3006 may include controls for the instrument interface logic 1002 (e.g., to initiate a second analysis mode for analyzing a portion of a sample, as discussed herein).

The settings region 3008 may include options that allow the user to control the features and functions of the GUI 3000 (and/or other GUIs) and/or perform common computing operations with respect to the data display region 3002 and data analysis region 3004 (e.g., saving data on a storage device, such as the storage device 4004 discussed herein with reference to FIG. 8, sending data to another user, labeling data, etc.). For example, the settings region 3008 may include controls for updating an ML model, deploying an ML model from a server, or other kinds of controls.

As noted above, the sample analysis module 1000 may be implemented by one or more computing devices. FIG. 8 is a block diagram of a computing device 4000 that may perform some or all of the sample analysis methods disclosed herein, in accordance with various embodiments. In some embodiments, the sample analysis module 1000 may be implemented by a single computing device 4000 or by multiple computing devices 4000. Further, as discussed below, a computing device 4000 (or multiple computing devices 4000) that implements the sample analysis module 1000 may be part of one or more of the scientific instrument 5010, the user local computing device 5020, the service local computing device 5030, or the remote computing device 5040 of FIG. 9.

The computing device 4000 of FIG. 8 is illustrated as having a number of components, but any one or more of these components may be omitted or duplicated, as suitable for the application and setting. In some embodiments, some or all of the components included in the computing device 4000 may be attached to one or more motherboards and enclosed in a housing (e.g., including plastic, metal, and/or other materials). In some embodiments, some of these components may be fabricated onto a single system-on-a-chip (SoC) (e.g., an SoC may include one or more processing devices 4002 and one or more storage devices 4004). Additionally, in various embodiments, the computing device 4000 may not include one or more of the components illustrated in FIG. 8, but may include interface circuitry (not shown) for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface) . For example, the computing device 4000 may not include a display device 4010, but may include display device interface circuitry (e.g., a connector and driver circuitry) to which a display device 4010 may be coupled.

The computing device 4000 may include a processing device 4002 (e.g., one or more processing devices). As used herein, the term "processing device" may refer to any device or portion of a device that processes electronic data from registers and/or memory to transform that electronic data into other electronic data that may be stored in registers and/or memory. The processing device 4002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 4000 may include a storage device 4004 (e.g., one or more storage devices). The storage device 4004 may include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 4004 may include memory that shares a die with a processing device 4002. In such an embodiment, the memory may be used as cache memory and may include embedded dynamic random access memory (eDRAM) or spin transfer torque magnetic random access memory (STT-MRAM), for example. In some embodiments, the storage device 4004 may include non-transitory computer readable media having instructions thereon that, when executed by one or more processing devices (e.g., the processing device 4002), cause the computing device 4000 to perform any appropriate ones of or portions of the methods disclosed herein.

The computing device 4000 may include an interface device 4006 (e.g., one or more interface devices 4006). The interface device 4006 may include one or more communication chips, connectors, and/or other hardware and software to govern communications between the computing device 4000 and other computing devices. For example, the interface device 4006 may include circuitry for managing wireless communications for the transfer of data to and from the computing device 4000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. Circuitry included in the interface device 4006 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). In some embodiments, circuitry included in the interface device 4006 for managing wireless communications may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 4006 for managing wireless communications may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 4006 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 4006 may include one or more antennas (e.g., one or more antenna arrays) to receipt and/or transmission of wireless communications.

In some embodiments, the interface device 4006 may include circuitry for managing wired communications, such as electrical, optical, or any other suitable communication protocols. For example, the interface device 4006 may include circuitry to support communications in accordance with Ethernet technologies. In some embodiments, the interface device 4006 may support both wireless and wired communication, and/or may support multiple wired communication protocols and/or multiple wireless communication protocols. For example, a first set of circuitry of the interface device 4006 may be dedicated to shorter-range wireless communications such as Wi-Fi or Bluetooth, and a second set of circuitry of the interface device 4006 may be dedicated to longer-range wireless communications such as global positioning system (GPS), EDGE, GPRS, CDMA, WiMAX, LTE, EV-DO, or others. In some embodiments, a first set of circuitry of the interface device 4006 may be dedicated to wireless communications, and a second set of circuitry of the interface device 4006 may be dedicated to wired communications.

The computing device 4000 may include battery/power circuitry 4008. The battery/power circuitry 4008 may include one or more energy storage devices (e.g., batteries or capacitors) and/or circuitry for coupling components of the computing device 4000 to an energy source separate from the computing device 4000 (e.g., AC line power).

The computing device 4000 may include a display device 4010 (e.g., multiple display devices). The display device 4010 may include any visual indicators, such as a heads-up display, a computer monitor, a projector, a touchscreen display, a liquid crystal display (LCD), a light-emitting diode display, or a flat panel display.

The computing device 4000 may include other input/output (I/O) devices 4012. The other I/O devices 4012 may include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 4000, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 4000 may have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer, etc.), a desktop computing device, or a server computing device or other networked computing component.

One or more computing devices implementing any of the sample analysis modules or methods disclosed herein may be part of a sample analysis system. FIG. 9 is a block diagram of an example sample analysis system 5000 in which some or all of the sample analysis methods disclosed herein may be performed, in accordance with various embodiments. The sample analysis modules and methods disclosed herein (e.g., the sample analysis module 1000 of FIG. 1 and the method 2000 of FIG. 4) may be implemented by one or more of the scientific instrument 5010, the user local computing device 5020, the service local computing device 5030, or the remote computing device 5040 of the sample analysis system 5000.

Any of the scientific instrument 5010, the user local computing device 5020, the service local computing device 5030, or the remote computing device 5040 may include any of the embodiments of the computing device 4000 discussed herein with reference to FIG. 8, and any of the scientific instrument 5010, the user local computing device 5020, the service local computing device 5030, or the remote computing device 5040 may take the form of any appropriate ones of the embodiments of the computing device 4000 discussed herein with reference to FIG. 8.

The scientific instrument 5010, the user local computing device 5020, the service local computing device 5030, or the remote computing device 5040 may each include a processing device 5002, a storage device 5004, and an interface device 5006. The processing device 5002 may take any suitable form, including the form of any of the processing devices 4002 discussed herein with reference to FIG. 8, and the processing devices 5002 included in different ones of the scientific instrument 5010, the user local computing device 5020, the service local computing device 5030, or the remote computing device 5040 may take the same form or different forms. The storage device 5004 may take any suitable form, including the form of any of the storage devices 4004 discussed herein with reference to FIG. 8, and the storage devices 5004 included in different ones of the scientific instrument 5010, the user local computing device 5020, the service local computing device 5030, or the remote computing device 5040 may take the same form or different forms. The interface device 5006 may take any suitable form, including the form of any of the interface devices 4006 discussed herein with reference to FIG. 8, and the interface devices 5006 included in different ones of the scientific instrument 5010, the user local computing device 5020, the service local computing device 5030, or the remote computing device 5040 may take the same form or different forms.

The scientific instrument 5010, the user local computing device 5020, the service local computing device 5030, and the remote computing device 5040 may be in communication with other elements of the sample analysis system 5000 via communication pathways 5008. The communication pathways 5008 may communicatively couple the interface devices 5006 of different ones of the elements of the sample analysis system 5000, as shown, and may be wired or wireless communication pathways (e.g., in accordance with any of the communication techniques discussed herein with reference to the interface devices 4006 of the computing device 4000 of FIG. 8). The particular sample analysis system 5000 depicted in FIG. 9 includes communication pathways between each pair of the scientific instrument 5010, the user local computing device 5020, the service local computing device 5030, and the remote computing device 5040, but this "fully connected" implementation is simply illustrative, and in various embodiments, various ones of the communication pathways 5008 may be absent. For example, in some embodiments, a service local computing device 5030 may not have a direct communication pathway 5008 between its interface device 5006 and the interface device 5006 of the scientific instrument 5010, but may instead communicate with the scientific instrument 5010 via the communication pathway 5008 between the service local computing device 5030 and the user local computing device 5020 and the communication pathway 5008 between the user local computing device 5020 and the scientific instrument 5010.

The scientific instrument 5010 may include any appropriate scientific instrument, such as a charged particle microscope (e.g., an electron microscope), an optical microscope, a spectroscopy device, or any other suitable analytical instrument.

The user local computing device 5020 may be a computing device (e.g., in accordance with any of the embodiments of the computing device 4000 discussed herein) that is local to a user of the scientific instrument 5010. In some embodiments, the user local computing device 5020 may also be local to the scientific instrument 5010, but this need not be the case; for example, a user local computing device 5020 that is in a user's home or office may be remote from, but in communication with, the scientific instrument 5010 so that the user may use the user local computing device 5020 to control and/or access data from the scientific instrument 5010. In some embodiments, the user local computing device 5020 may be a laptop, smartphone, or tablet device. In some embodiments the user local computing device 5020 may be a portable computing device.

The service local computing device 5030 may be a computing device (e.g., in accordance with any of the embodiments of the computing device 4000 discussed herein) that is local to an entity that services the scientific instrument 5010. For example, the service local computing device 5030 may be local to a manufacturer of the scientific instrument 5010 or to a third-party service company. In some embodiments, the service local computing device 5030 may communicate with the scientific instrument 5010, the user local computing device 5020, and/or the remote computing device 5040 (e.g., via a direct communication pathway 5008 or via multiple "indirect" communication pathways 5008, as discussed above) to receive data regarding the operation of the scientific instrument 5010, the user local computing device 5020, and/or the remote computing device 5040 (e.g., the results of self-tests of the scientific instrument 5010, calibration coefficients used by the scientific instrument 5010, the measurements of sensors associated with the scientific instrument 5010, etc.). In some embodiments, the service local computing device 5030 may communicate with the scientific instrument 5010, the user local computing device 5020, and/or the remote computing device 5040 (e.g., via a direct communication pathway 5008 or via multiple "indirect" communication pathways 5008, as discussed above) to transmit data to the scientific instrument 5010, the user local computing device 5020, and/or the remote computing device 5040 (e.g., to update programmed instructions, such as firmware, in the scientific instrument 5010, to initiate the performance of test or calibration sequences in the scientific instrument 5010, to update programmed instructions, such as software, in the user local computing device 5020 or the remote computing device 5040, etc.). A user of the scientific instrument 5010 may utilize the scientific instrument 5010 or the user local computing device 5020 to communicate with the service local computing device 5030 to report a problem with the scientific instrument 5010 or the user local computing device 5020, to request a visit from a technician to improve the operation of the scientific instrument 5010, to order consumables or replacement parts associated with the scientific instrument 5010, or for other purposes.

The remote computing device 5040 may be a computing device (e.g., in accordance with any of the embodiments of the computing device 4000 discussed herein) that is remote from the scientific instrument 5010 and/or from the user local computing device 5020. In some embodiments, the remote computing device 5040 may be included in a datacenter or other large-scale server environment. In some embodiments, the remote computing device 5040 may include network-attached storage (e.g., as part of the storage device 5004). The remote computing device 5040 may store data generated by the scientific instrument 5010, perform analyses of the data generated by the scientific instrument 5010 (e.g., in accordance with programmed instructions), facilitate communication between the user local computing device 5020 and the scientific instrument 5010, and/or facilitate communication between the service local computing device 5030 and the scientific instrument 5010. In some embodiments, the remote computing device may be a server that manages and deploys ML models and implements new classifications for previously unclassified ROIs, as discussed herein.

In some embodiments, one or more of the elements of the sample analysis system 5000 illustrated in FIG. 9 may not be present. Further, in some embodiments, multiple ones of various ones of the elements of the sample analysis system 5000 of FIG. 9 may be present. For example, a sample analysis system 5000 may include multiple user local computing devices 5020 (e.g., different user local computing devices 5020 associated with different users or in different locations). In another example, a sample analysis system 5000 may include multiple scientific instruments 5010, all in communication with service local computing device 5030 and/or a remote computing device 5040; in such an embodiment, the service local computing device 5030 may monitor these multiple scientific instruments 5010, and the service local computing device 5030 may cause updates or other information may be "broadcast" to multiple scientific instruments 5010 at the same time. Different ones of the scientific instruments 5010 in a sample analysis system 5000 may be located close to one another (e.g., in the same room) or farther from one another (e.g., on different floors of a building, in different buildings, in different cities, etc.). In some embodiments, a scientific instrument 5010 may be connected to an Internet-of-Things (IoT) stack that allows for command and control of the scientific instrument 5010 through a web-based application, a virtual or augmented reality application, a mobile application, and/or a desktop application. Any of these applications may be accessed by a user operating the user local computing device 5020 in communication with the scientific instrument 5010 by the intervening remote computing device 5040. In some embodiments, a scientific instrument 5010 may be sold by the manufacturer along with one or more associated user local computing devices 5020 as part of a local scientific instrument computing unit 5012.

The following paragraphs provide various examples of the embodiments disclosed herein.

Example A includes any of the sample analysis modules disclosed herein.

Example B includes any of the methods disclosed herein.

Example C includes any of the GUIs disclosed herein.

Example D includes any of the sample analysis computing devices and systems disclosed herein.

Example 1 is a method for classifying microscopic components of a physical sample, including: generating a set of regions-of-interest (ROIs) in an image representative of the physical sample, wherein the image is generated by a microscopy system using a first analysis mode; generating an initial classification for an ROI by applying a trained machine-learning model to at least a portion of the image associated with the ROI; generating a confidence score associated with the initial classification; and when the confidence score for an initial classification of an ROI does not satisfy a set of confidence criteria, causing the microscopy system to re-analyze at least a portion of the sample associated with the ROI using a second analysis mode different than the first analysis mode.

Example 2 includes the subject matter of Example 1, and further specifies that the microscopy system takes less time to image the portion of the sample associated with the ROI using the first analysis mode than using the second analysis mode.

Example 3 includes the subject matter of any of Examples 1-2, and further specifies that the first analysis mode includes backscattered electron detection (BSED).

Example 4 includes the subject matter of Example 3, and further specifies that the second analysis mode includes energy dispersive spectroscopy (EDS).

Example 5 includes the subject matter of any of Examples 1-4, and further specifies that some but not all of the ROIs are re-analyzed using the second analysis mode.

Example 6 includes the subject matter of any of Examples 1-5, and further specifies that generating the set of ROIs includes applying a machine-learning segmentation technique to the image.

Example 7 includes the subject matter of any of Examples 1-6, and further specifies that an individual ROI in the image corresponds to an individual particle in the physical sample.

Example 8 includes the subject matter of Example 7, and further specifies that the initial classification for an ROI is selected from a set of at least two classifications, and the set of at least two classifications includes gunshot residue (GSR) and not GSR.

Example 9 includes the subject matter of Example 7, and further specifies that the initial classification for an ROI is selected from a set of at least two classifications, and the set of at least two classifications includes abrasive and soft.

Example 10 includes the subject matter of any of Examples 1-9, and further includes: when the confidence score for an initial classification of an ROI does not satisfy the set of confidence criteria, using data generated by the re-analyzing to generate a final classification for the ROI.

Example 11 includes the subject matter of Example 10, and further specifies that the data generated by the re-analyzing includes elemental composition data.

Example 12 includes the subject matter of any of Examples 10-11, and further includes: when the confidence score for an initial classification of an ROI does satisfy a set of confidence criteria, using the initial classification of the ROI as a final classification of the ROI.

Example 13 includes the subject matter of Example 12, and further includes: outputting a classification report that includes the final classification of individual ROIs in the set of ROIs.

Example 14 includes the subject matter of Example 13, and further specifies that the classification report includes locations of individual ROls.

Example 15 includes the subject matter of any of Examples 13-14, and further specifies that the classification report includes morphological characteristics of the portion of the sample corresponding to individual ROls.

Example 16 includes the subject matter of Example 15, and further specifies that the morphological characteristics include area, roundness, or roughness.

Example 17 includes the subject matter of any of Examples 1-16, and further includes: before generating an initial classification for an ROI by applying a trained machine-learning model, receiving the machine-learning model from a central server.

Example 18 includes the subject matter of Example 17, and further specifies that the central server is to deploy the machine-learning model to multiple microscopy systems.

Example 19 includes the subject matter of any of Examples 1-18, and further specifies that the initial classification for an ROI is selected from a set of at least two classifications, and the set of at least two classifications includes unclassified.

Example 20 includes the subject matter of Example 19, and further includes: when the initial classification of an ROI is unclassified, receiving a final classification for the ROI upon notification from a central server that a classification is available.

Example 21 is a method for generating a machine-learning model for classifying microscopic components of a physical sample, including: receiving first data representative of the physical sample, wherein the first data is generated by a microscopy system using a first analysis mode; receiving classification data representative of classifications of regions-of-interest (ROIs) in the first data, wherein the classification data was generated based at least in part on second data, different from the first data, of the physical sample, wherein the second data was generated by the microscopy system using a second analysis mode different from the first analysis mode; training a machine-learning model, using data representative of the first analysis data and the classification data, and not using the second data, to generate a classification for an ROI in data generated by the microscopy system using the first analysis mode.

Example 22 includes the subject matter of Example 21, and further includes: after training the machine-learning model, generating a training performance score.

Example 23 includes the subject matter of Example 22, and further includes: when the training performance score does not meet training performance criteria, re-training the machine-learning model based on additional first data and additional corresponding classification data.

Example 24 includes the subject matter of Example 22, and further includes: when the training performance score meets training performance criteria, providing the machine-learning model to generate classifications for ROIs in additional images of physical samples, wherein the additional images are generated by the microscopy system using the first analysis mode.

Example 25 includes the subject matter of any of Examples 21-24, and further specifies that the microscopy system takes less time to image a portion of a sample using the first analysis mode than using the second analysis mode.

Example 26 includes the subject matter of any of Examples 21-25, and further specifies that the first analysis mode includes backscattered electron detection (BSED).

Example 27 includes the subject matter of Example 26, and further specifies that the second analysis mode includes energy dispersive spectroscopy (EDS).

Example 28 includes the subject matter of any of Examples 21-27, and further includes: generating the ROIs in the first data.

Example 29 includes the subject matter of Example 28, and further specifies that generating the ROIs includes applying a machine-learning segmentation technique to the first data.

Example 30 includes the subject matter of any of Examples 21-29, and further specifies that an individual ROI in the first data corresponds to an individual particle in the physical sample.

Example 31 includes the subject matter of any of Examples 21-30, and further specifies that the classifications generated by the machine-learning model are selected from a set of at least two classifications, and the set of at least two classifications includes gunshot residue (GSR) and not GSR.

Example 32 includes the subject matter of any of Examples 21-30, and further specifies that the classifications generated by the machine-learning model are selected from a set of at least two classifications, and the set of at least two classifications includes abrasive and soft.

Example 33 includes the subject matter of any of Examples 21-32, and further specifies that the second data includes elemental composition data.

Example 34 includes the subject matter of any of Examples 21-33, and further specifies that training the machine-learning model using data representative of the first analysis data includes training the machine-learning model using the first analysis data.

Example 35 includes the subject matter of any of Examples 21-33, and further specifies that training the machine-learning model using data representative of the first analysis data includes training the machine-learning model using morphological parameters generated at least in part from the first analysis data.

Example 36 includes the subject matter of Example 35, and further specifies that the morphological parameters include area, roundness, or roughness.

Example 37 includes the subject matter of any of Examples 21-36, and further specifies that the machine-learning model is configured to receive a two-dimensional image as an input.

Example 38 includes the subject matter of any of Examples 21-36, and further specifies that the machine-learning model is configured to receive a one-dimensional vector as an input.

Example 39 includes the subject matter of Example 38, and further specifies that the one-dimensional vector includes at least some morphological parameters.

Example 40 includes the subject matter of any of Examples 21-39, and further includes: deploying the machine-learning model to multiple microscopy systems.

Example 41 is a method for classifying microscopic components of a physical sample, including: receiving first analysis mode data representative of a set of regions-of-interest (ROIs) in images representative of a physical sample, wherein the ROIs were previously classified by a machine-learning model as not corresponding to a known classification, and wherein the first analysis mode data was generated by a microscopy system using a first analysis mode; clustering the first analysis mode data based on similarities between the first analysis mode data corresponding to different ROIs; receiving new first analysis mode data representative of a new ROI; determining that the new first analysis mode data indicates that the new ROI belongs to a particular cluster; receiving second analysis mode data representative of the new ROI, wherein the second analysis mode data was generated by a microscopy system using a second analysis mode different from the first analysis mode; providing a list of ROIs in the particular cluster and the second analysis mode data to a user; receiving an identification of a new classification associated with the particular cluster; and re-classifying the ROIs in the particular cluster to the new classification.

Example 42 includes the subject matter of Example 41, and further specifies that the microscopy system takes less time to image the portion of the sample associated with the ROI using the first analysis mode than using the second analysis mode.

Example 43 includes the subject matter of any of Examples 41-42, and further specifies that the first analysis mode includes backscattered electron detection (BSED).

Example 44 includes the subject matter of Example 43, and further specifies that the second analysis mode includes energy dispersive spectroscopy (EDS).

Example 45 includes the subject matter of any of Examples 41-44, and further specifies that an individual ROI corresponds to an individual particle in the physical sample.

Example 46 includes the subject matter of any of Examples 41-45, and further includes: after re-classifying the ROIs, outputting a classification report that includes classifications of individual ROIs of the physical sample.

Example 47 includes the subject matter of Example 46, and further specifies that the classification report includes locations of individual ROls.

Example 48 includes the subject matter of any of Examples 46-47, and further specifies that the classification report includes morphological characteristics of portions of the physical sample corresponding to individual ROls.

Example 49 includes the subject matter of any of Examples 41-48, and further specifies that the microscopy system is a charged particle microscopy system.

Example 50 includes the subject matter of any of Examples 41-49, and further specifies that the physical sample is a non-biological sample.

Example 51 includes the subject matter of any of Examples 41-49, and further specifies that receiving the identification of the new classification includes receiving a user specification of the new classification.

Example 52 includes the subject matter of Example 51, and further specifies that the user specification is received through a graphical user interface.

## Claims

1. A method for classifying microscopic components of a physical sample, comprising:
generating a set of regions-of-interest (ROIs) in an image representative of the physical sample, wherein the image is generated by a microscopy system using a first analysis mode;
generating an initial classification for an ROI by applying a trained machine-learning model to at least a portion of the image associated with the ROI;
generating a confidence score associated with the initial classification; and
when the confidence score for an initial classification of an ROI does not satisfy a set of confidence criteria, causing the microscopy system to re-analyze at least a portion of the sample associated with the ROI using a second analysis mode different than the first analysis mode.

2. The method of claim 1, wherein the microscopy system takes less time to image the portion of the sample associated with the ROI using the first analysis mode than using the second analysis mode.

3. The method of any of claims 1 or 2, wherein the first analysis mode includes backscattered electron detection (BSED).

4. The method of claim 3, wherein the second analysis mode includes energy dispersive spectroscopy (EDS).

5. The method of any of claims 1-4, wherein some but not all of the ROIs are re-analyzed using the second analysis mode.

6. The method of any of claims claim 1-5, wherein generating the set of ROIs includes applying a machine-learning segmentation technique to the image.

7. The method of any of claims 1-6, wherein an individual ROI in the image corresponds to an individual particle in the physical sample.

8. The method of claim 7, wherein the initial classification for an ROI is selected from a set of at least two classifications, and the set of at least two classifications includes gunshot residue (GSR) and not GSR.

9. The method of claim 7, wherein the initial classification for an ROI is selected from a set of at least two classifications, and the set of at least two classifications includes abrasive and soft.

10. The method of any of claims 1-9, further comprising:
when the confidence score for an initial classification of an ROI does not satisfy the set of confidence criteria, using data generated by the re-analyzing to generate a final classification for the ROI.

11. The method of claim 10, further comprising:
when the confidence score for an initial classification of an ROI does satisfy a set of confidence criteria, using the initial classification of the ROI as a final classification of the ROI.

12. The method of claim 11, further comprising:
outputting a classification report that includes the final classification of individual ROIs in the set of ROIs.

13. The method of claim 12, wherein the classification report includes locations of individual ROIs.

14. The method of claims 12 or 13, wherein the classification report includes morphological characteristics of the portion of the sample corresponding to individual ROls.

15. The method of any of claims 1-13, wherein the initial classification for an ROI is selected from a set of at least two classifications, and the set of at least two classifications includes unclassified, and wherein the method further comprises:
when the initial classification of an ROI is unclassified, receiving a final classification for the ROI upon notification from a central server that a classification is available.
